# EUROPEAN PATENT SPECIFICATION

(11) **EP 0 427 003 B1**
(45) Date of publication and mention of the grant of the patent: **27.03.1996**
(21) Application number: 90119687.3
(22) Date of filing: 15.10.1990
(51) Int. Cl.: H01L 33/00, H01S 3/19

(54) **Semiconductor light-emitting element and its manufacturing method**
Lichtemittierende Halbleitervorrichtung und Herstellungsverfahren
Elément semi-conducteur émetteur de lumière et méthode de fabrication

(30) Priority: 16.10.1989 JP 268782/89
(43) Date of publication of application: 15.05.1991
(73) Proprietor: KABUSHIKI KAISHA TOSHIBA, Kawasaki-shi, Kanagawa-ken 210, Tokyo (JP)
(72) Inventor: Yuge, Shozo, c/o Intellectual Property Div., Tokyo 105 (JP); Kinoshita,Hideaki, c/o Intellectual Property Div., Tokyo 105 (JP)
(74) Representative: Lehn, Werner, Dipl.-Ing.

(56) References cited:
- EP-A- 0 328 134
- EP-A- 0 334 637
- ELECTRONICS LETTERS. vol. 19, no. 5, March 1983, ENAGE GB pages 163 - 165; Y. KAWASURA ET AL.: "0.66 MICROMETERS ROOM-TEMPERATURE OPERATION OF InGaAlP DH LASER DIODES GROWN BY MBE"
- ELECTRONICS LETTERS. vol. 21, no. 24, November 1985, ENAGE GB pages 1162 - 1163; K.KOBAYASHI ET AL.: "661.7 nm ROOM-TEMPERATURE CW OPERATION OF AlGaInP DOUBLE HETEROSTRUCTURE LASERS WITH ALUMINIUM-CONTAINING QUATERNARY ACTIVE LAYER"
- ELECTRONICS LETTERS. vol. 22, no. 23, November 1986, ENAGE GB pages 1265 - 1266; S.KAWATA ET AL.: "621 nm CW OPERATION (0 C) OF AlGaInP VISIBLE SEMICONDUCTOR LASERS"
- APPLIED PHYSICS LETTERS. vol. 50, no. 8, 23 February 1987, NEW YORK US pages 427 - 429; M.WATANABE ET AL.: "OPTICAL TRISTABILITY USING A TWIN-STRIPE LASER DIODE"
- IEEE JOURNAL OF QUANTUM ELECTRONICS. vol. 23, no. 6, June 1987, NEW YORK US pages 704 - 711; K.KOBAYASHI ET AL.: "AlGaInP DOUBLE HETEROSTRUCTURE VISIBLE- LIGHT LASER DIODES WITH A GaInP ACTIVE LAYER GROWN BY METALORGANIC VAPOR PHASE EPITAXY"

## Description

The present invention relates to a semiconductor light-emitting element having a double hetero structure and, more particularly to a semiconductor light-emitting element such as a high output laser diode having an active layer formed of InGaAℓP crystal and a light-emitting wavelength of about 670 nm.

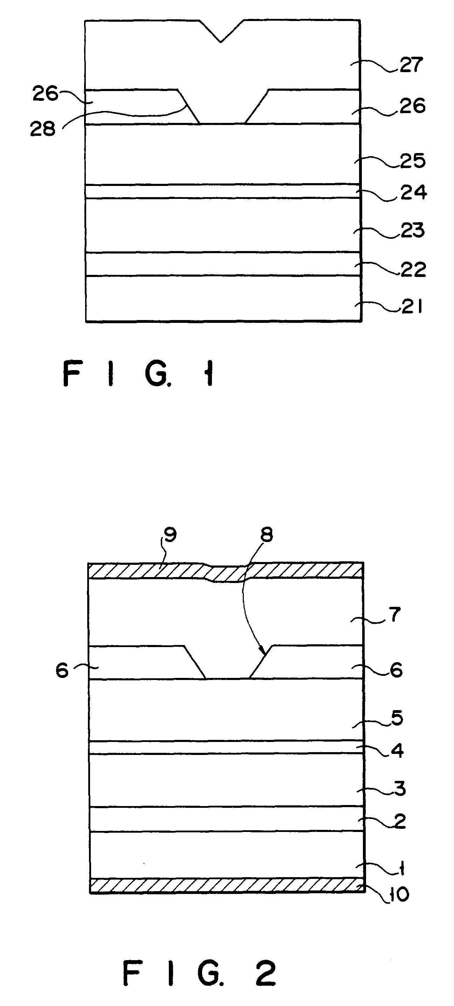

Semiconductor lasers of InGaAℓP system have been widely used in reading light sources which are employed in a bar-code reader or a laser printer, etc. Fig. 1 is a cross sectional view showing an inner stripe (IS) structure as an example of a conventional laser of InGaAℓP system having a double hetero junction structure manufactured by a metalorganic chemical vapor deposition method (MOCVD) or a molecular beam epitaxial method (MBE).

In Fig. 1, as a first growth, n-type GaAs buffer layer 22, n-type In_{1-y} (Ga₁₋ₛ Aℓₛ)_{y} P cladding layer 23, undoped In_{1-y} (Ga₁₋ₓ Aℓₓ)_{y} P active layer 24, p-type In_{1-y} (Ga₁₋ₛ Aℓₛ)_{y} P cladding layer 25, and n-type GaAs current stripe layer 26 are sequentially formed on n-type GaAs substrate 21 by MOCVD method. Then, a resist pattern having a stripe-shaped opening is formed on the upper portion by a photolithograph method. Thereafter, a stripe-shaped window portion 28 reaching p-type InGaAℓ P cladding layer 25 is formed by etching the n-type GaAs current stripe layer 26 with solution in which GaAs is etched and InGaAℓP is not etched, thereafter, the resist pattern is removed. Next, the second crystal growth is performed by the MOCVD method, thereby forming p-type GaAs ohmic contact layer 27. In this way, a typical gain waveguide typed semiconductor laser element can be obtained. In the IS laser element, Zn is normally used as p-type dopant and Si is used as n-type dopant.

The outline of the operation of the above IS laser will be explained as follows:

Metallic electrodes (not shown) are respectively adhered onto the upper and lower surfaces of the formed substrate shown in Fig. 1, and a forward voltage (the electrode of the upper surface is positive and that of the lower surface is negative) is applied thereto when the laser is operated. A hole is injected into the active layer 24 from p-type cladding layer 25 and an electron is injected into the active layer 24 from n-type cladding layer 23. Since n-type current stripe layer 26 and p-type cladding layer 25 are reverse biased, an exciting current locally flows into the portion of p-type ohmic contact layer 27 embedding the stripe-shaped window portion 28. In other words, the implantation of the above carrier is limited to the portion which is close to the portion just below the stripe-shaped window portion 28.

A mixed crystal ratio of materials is determined in order to make the band-gap energy of the active layer 24 smaller than that of the cladding layers 23 and 25. Due to this, the implanted carrier is closed in the thin active layer 24 with a high density and the electron of the conduction band and the hole of the valence band are recombined, thereby emitting light having a wavelength corresponding to the band-gap energy.

On the other hand, the upper and lower surfaces of the active layer 24 are sandwiched between the cladding layers 23 and 25 whose index of refraction is smaller than that of the active layer 24. Due to this, the above-emitted light is enclosed in the active layer 24. In the case of the semiconductor laser, the active layer portion close to the portion just below the stripe-shaped window portion 28 in its longitudinal direction is a light-emitting region, and reflecting mirror surfaces (not shown) are formed to be parallel with the both end surfaces of the light-emitting region. The active layer portion, which is sandwiched between the parallel reflecting mirror surfaces, becomes an optical resonator. Light emitted in the active layer is amplified by induced radiation, so that laser beam can be obtained.

Additionally, when layers 23 to 27 are formed on the substrate 21 one over another n-type GaAs buffer layer 22 relaxes a lattice mismatching. At the same time, n-type GaAs buffer layer 22 relaxes the increase of the lattice defect in the crystal growth layer or the generation thereof.

In the above-mentioned semiconductor light-emitting element, the following problems occur in the process of the crystal growth.

Specifically, dopant of p-type cladding layer 25 hetero junctioning undoped active layer 24, such as Zn disperses into undoped active layer 24 during the crystal growth. Due to this, there is a problem in that the conductivity type of active layer 24 becomes the p-type conductivity, thereby increasing band-gap energy in the active layer. For this reason, an oscillation wavelength is shifted to a short wavelength and index of refraction of the active layer is decreased, so that the threshold current of the vibration is increased. For the above-mentioned reasons, there are problems in that yield of the element and reliance thereof are lowered. EP-A-0328134 describes a semiconductor laser device using double heterostructure comprised of
InₓGa_{y}Aℓ_{1-x-y}P (0 ≤ x ≤ 1, 0 ≤ y ≤ 1), capable of preventing the leakage of the carriers and thereby reducing the threshold current, being operative with small threshold current density and at high temperature, and having a long lifetime. The device may include a double heterostructure formed on the GaAs substrate, comprised of
Inₓ-Ga_{y}Aℓ_{1-x-y}P (0 ≤ x ≤ 1, 0 ≤ y ≤ 1) including an active layer, the active layer having an impurity concentration not greater than 5 x 10¹⁶cm⁻³. The device may include a double heterostructure formed on the GaAs substrate, comprised of InGaP active layer and p-type
In_{q}(Ga_{1-z}Aℓ_{z})_{q}P (0 ≤ q ≤ 1, 0 ≤ z ≤ 1) cladding layer with a value of z between 0.65 and 0.75. The device may include a double heterostructure formed on the GaAs substrate, comprised of Inₓ₋Ga_{y}Aℓ_{1-x-y}P (0 ≤ x ≤ 1, 0 ≤y ≤ 1) including an n-type cladding layer and a p-type cladding layer one of the n-type cladding layer and the p-type cladding layer being Si-doped. A method of manufacturing the device is also disclosed.

The article in "Electronic Letters", vol. 19, no. 15, 3 March 1983, pages 163-165 by Y. Kawamura et. al. entitled "0.66µm Room-temperature Operation of InGaAℓP DH Laser Diodes grown by MBE" describes room-temperature pulsed operation of In_{0.49}Ga_{0.31}Aℓ_{0.20}P In_{0.49}Ga_{0.48}Aℓ_{0.03}P/In_{0.49}Ga_{0.31}Aℓ_{0.20}P double heterostructure (DH) laser diodes. The DH layers were grown by molecular beam epitaxy. The lasing wavelength was 0.66 µm and the threshold current density was 3.2-3.6x10⁴ A/cm at room temperature. The active layer was p-doped.

Accordingly, an object of the present invention is to provide a semiconductor light-emitting element having a double hetero junction structure of InGaAℓP system, which can prevent dopant of p-type InGaAℓP cladding layer such as Zn from being dispersed in In_{1-y} (Ga₁₋ₓ Aℓₓ)_{y} P active layer during the crystal growth.

Another object of the present invention is to provide a semiconductor light-emitting element wherein a light-emitting wavelength of the light-emitting element is not shifted to a short wavelength.

Further another object of the present invention is to provide a semiconductor light-emitting element wherein a threshold current of an oscillation of the light-emitting element is not increased.

Further another object of the present invention is to improve yield and reliance of a semiconductor light-emitting element.

These objects of the present invention can be achieved by a semiconductor light-emitting element, comprising a double hetero junction structure formed by stacking a p-type InGaAℓP cladding layer having a band-gap energy, which is larger than that of an active layer of In_{1-y}(Ga₁₋ₓAℓₓ)_{y} P (0 ≤ x < 1, y = 0.5), and an n-type InGaAℓP cladding layer, said active layer being sandwiched between said cladding layers and characterised in that an n-type dopant, which does not change the crystal structure of said active layer, is doped in said active layer.

It is considered that the crystal structure of the active layer comprising said InGaP or InGaAℓP forms a superlattice explained later. If, for example, Zn is dispersed in the active layer, the alignment of the superlattice is disturbed, so that InGaP or InGaAℓP is alloyed. The band-gap energy Eg of the alloyed active layer is larger than that of the superlattice. Therefore, if the dopant of p-type cladding layer is dispersed in the active layer, the crystal structure of the active layer changes, the band-gap energy Eg is increased, the oscillation wavelength is shifted to the short wavelength, and the threshold current of the oscillation is raised. In contrast, according to the present invention, in a case where Si is doped into the active layer, since the alignment of the superlattice is not disturbed, the band-gap energy Eg is not changed, and neither the oscillation wavelength nor the threshold current are changed.

In the present invention, Si serving as an n-type dopant is doped into the active layer of InGaP or InGaAℓP, thereby the active layer becomes an n-type active layer. Si is substituted for In, Ga of the elements of III group, and used as a donor. Due to this, when p-type InGaAℓP cladding layer is crystal-grown on the n-type active layer, in which Si is doped, at a predetermined temperature, it is difficult for Zn to enter the active layer since the doped Si has already entered the lattice defect existing in the active layer. Thereby, dopant Zn of p-type cladding layer can be substantially prevented from being dispersed to the active layer, and the alignment of the superlattice is not easily disturbed. The reason why Zn is not dispersed is considered as mentioned above. However, the reason is not limited to the above.

These objects of the present invention can also be achieved by a method for manufacturing a semiconductor light-emitting element, having a double hetero junction structure, comprising the steps of: forming an n-type InGaAℓP cladding layer; forming an active layer of In_{1-y} (Ga₁₋ₓAℓₓ)_{y} P (0≤ x <1, y=0.5) including an n-type dopant which does not change the crystal structure of the active layer, on said cladding layer; forming a p-type InGaAℓP cladding layer on said active layer, whereby a layer structure to sandwich said n-type active layer between the layers is formed.

As an embodiment of the semiconductor light-emitting element of the present invention, a visible light semiconductor laser element of InGaAℓP system and a light-emitting diode element will be explained with reference to the drawings.

This invention can be more fully understood from the following detailed description when taken in conjunction with the accompanying drawings, in which:
Fig. 1 is a cross sectional view showing a conventional semiconductor light-emitting element;
Fig. 2 is a cross sectional view showing a semiconductor light-emitting element of an embodiment according to the present invention;
Figs. 3A and 3B are cross sectional views showing a manufacturing process of the semiconductor element of Fig. 2;
Fig. 4 is a cross sectional view showing a light emitting diode (LED) according to the present invention; and
Fig. 5 is a graph showing a relationship between a InGaP crystal growth temperature and a band-gap energy Eg.

Fig. 2 is a typical cross sectional view of the semiconductor element according to the present invention. In Fig. 2, an n-type GaAs buffer layer 2 is formed on an n-type GaAs substrate 1. A double hetero junction structure, which is formed to sandwiched an n-type InGaAℓP active layer 4 between an n-type InGaAℓP cladding layer 3 and a p-type InGaAℓP cladding layer 5, is formed on the buffer layer 2. An n-type GaAs current stripe layer 6 having a stripe-shaped window portion 8 and a p-type GaAs ohmic contact layer 7 are sequentially formed. Metallic electrodes 9 and 10 are adhered onto the upper and lower surfaces of the above-stacked substrate.

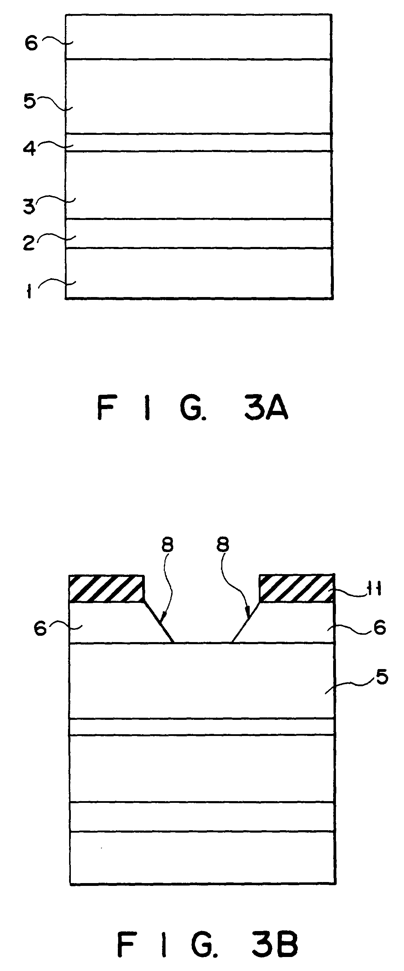

The outline of the method for manufacturing the above semiconductor laser element will be explained with reference to Fig. 3.

As shown in Fig. 3, it is assumed that a donor concentration is n and an acceptor concentration is p. The n-type GaAs buffer layer 2 wherein n = 5 × 10¹⁷ atoms/cm³ and its thickness is 0.5 µm, the n-type In_{1-y} (Ga₁₋ₛ Aℓₛ)_{y} P cladding layer 3 wherein n = 5 × 10¹⁷ atoms/cm³ and its thickness is 0.9 µm, the n-type In_{1-y} (Ga₁₋ₓ Aℓₓ)_{y} P active layer 4 wherein n = 1 × 10¹⁹ atoms/cm³ and its thickness is 0.06 µm, the p-type In_{1-y} (Ga₁₋ₛ Aℓₛ)_{y} P cladding layer 5 wherein p = 3 × 10¹⁷ atoms/cm³ and its thickness is 0.9 µm, and the n-type GaAs current stripe layer 6 wherein n = 2 × 10¹⁸ atoms/cm³ and its thickness is 0.6 µm are sequentially formed on the n-type GaAs substrate 1 by a metalorganic chemical vapor deposition method (MOCVD). In this case, the crystal growth temperature is about 720°C. In the present invention, x = 0, y = 0.5, and s = 0.7 and Si is used as an n-type impurity material (donor) and Zn is used as a p-type impurity material (acceptor).

As shown in Fig. 3, a resist film 11 having a stripe-shaped opening is formed on n-type current stripe layer 6 by a photolithograph method. The resist film 11 is used as a mask, and stripe-shaped window portion 8 is formed in the n-type current stripe layer 6 by etching the n-type current stripe layer 6 with etchant of H₂SO₄ : H₂O₂ : H₂O = 8 : 1 : 1 having selectivity in which GaAs can be etched but InGaAℓP cannot be etched at temperature of 20°C.

Then, the resist film 11 is removed and a surface cleaning process is performed. Thereafter, a second crystal growth is performed by MOCVD method and p-type GaAs ohmic contact layer 7 is formed. Then, the metallic electrodes 9 and 10 are adhered onto the upper and lower surfaces of the formed substrate by vapor deposition, thereby obtaining a semiconductor laser element as shown in Fig. 3.

The active layer of the laser element according to the above embodiment is formed of InGaP crystal wherein mixed ratio x = 0, y = 0.5. The semiconductor laser is different from the conventional semiconductor laser element in that Si is doped in InGaP active layer and InGaP active layer is n-conductivity type. However, the semiconductor laser element of the present invention is substantially equal to the conventional element in view of the operation and function as a laser element.

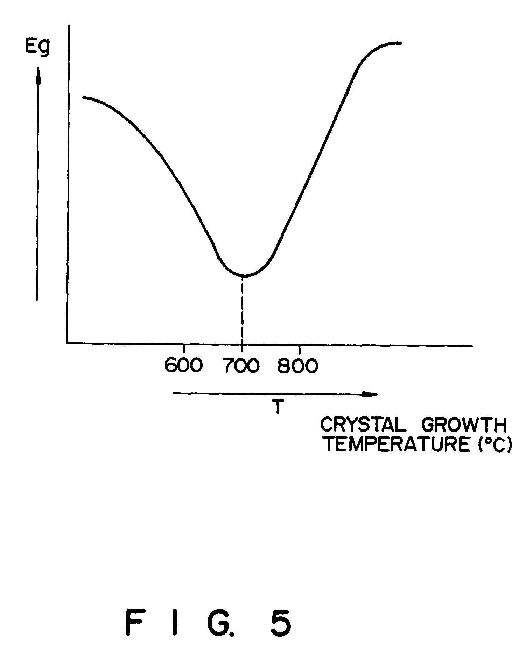

In a case of InGaP crystal there is a relationship between the crystal growth temperature and the band-gap energy Eg as shown in Fig. 5 (Reference: Journal of Crystal Growth, 93 (1988), p 406 to p 411). In Fig. 5, a horizontal axis denotes InGaP crystal growth temperature and a vertical axis denotes a band-gap energy Eg. To obtain a laser oscillation wavelength of about 670 ± 10nm, the growth temperature must be 650 to 720°C. Under this growth temperature, undoped InGaP forms superlattice. However, there is a lattice defect even in the superlattice. Then if Zn is dispersed in the lattice defect, the alignment of the superlattice is disturbed, so that InGaP is alloyed. Therefore, if the dopant of p-type cladding layer is dispersed in the active layer, the crystal structure of the active layer changes, the band-gap energy Eg is increased, the oscillation wavelength is shifted to the short wavelength, and the threshold current of the oscillation is raised. In contrast, according to the present invention, in a case where Si is doped into the active layer, since the alignment of the superlattice is not disturbed, the band-gap energy Eg is not changed, and neither the oscillation wavelength nor the threshold current is not changed.

In the above-mentioned semiconductor laser element, Si serving as an n-type dopant is doped into the InGaP active layer, thereby the active layer becomes an n-type active layer. Therefore, dopant Zn of p-type cladding active layer can be prevented from being dispersed to the active layer by Si, and the alignment of the superlattice is not easily disturbed. The reason is considered that when Si is substituted for In, Ga of the elements of III group, and used as a donor and when p-type InGaAℓP cladding layer is crystal-grown on n-type active layer, in which Si is doped, at a predetermined temperature, Si enters the lattice defect existing in the active layer, thereby Si covers the lattice defect. However, the reason why Zn is prevented from being dispersed is not limited to the above reason.

The above embodiment explained the active layer of the ternary mixed crystal which is In_{1-y} (Ga₁₋ₓ Aℓₓ)_{y} P active layer where y = 0.5 and x = 0. However, the present invention can be applied to the active layer of the quaternary mixed crystal of x ≠ 0 such as In_{0.5} (Ga_{0.8} Aℓ_{0.2}) _{0.5}P wherein x = 0.2. In this case, it is necessary to satisfy the laser oscillation condition while the lattice matching of both active layer and the cladding layer is maintained by selecting the composition ratio x, y of the active layer and the composition ratio s, y of the cladding layer.

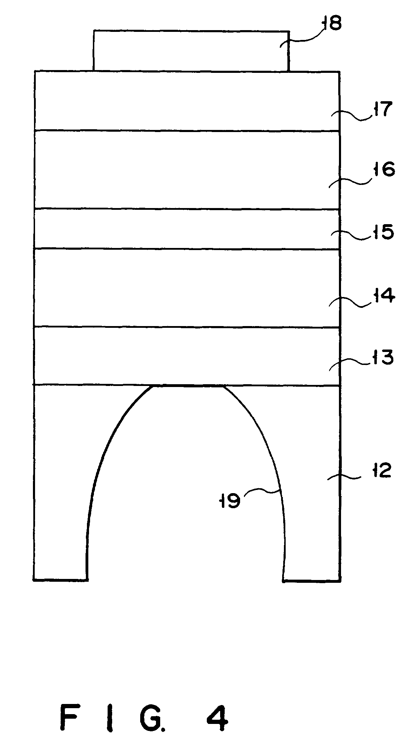

Moreover, the above embodiment explained the semiconductor laser element having an oscillation wavelength of about 670 nm as a semiconductor light-emitting element. However, the present invention is not limited to this element. The present invention can be applied to a semiconductor laser element having a different oscillation wavelength from the embodiment or a light-emitting diode (LED) for optical communication. Fig. 4 shows an LED having an inner stripe structure. In Fig. 4, reference numeral 12 denotes a GaAs substrate; 13: an n-type GaAs buffer layer; 14: an n-type In_{0.5} (Ga_{0.3} Aℓ_{0.7}) _{0.5} P cladding layer; 15: an n-type In_{0.5} (Ga_{0.8} Aℓ_{0.2}) _{0.5} P active layer; 16: a p-type In_{0.5} (Ga_{0.3} Aℓ_{0.7}) _{0.5} P cladding layer; 17: a p-type GaAℓAS conductive layer; and 18: a p-type GaAs contact layer. These layers are sequentially stacked on the substrate, and metallic electrodes are adhered onto the upper and lower surfaces (not shown). The above structure is substantially the same as the structure of the laser element of Fig. 2 excepting that thickness of the layer is a little different of that of the laser element of Fig. 2 and the substrate 12 is removed at a portion 19 by etching in order that light is not absorbed by the substrate 12 since light emits in the vertical direction.

Reference signs in the claims are intended for better understanding and shall not limit the scope.

## Claims

1. A semiconductor light-emitting element, comprising a double hetero junction structure formed by stacking a p-type InGaAℓP cladding layer (5) having a band-gap energy, which is larger than that of an active layer (4) of In_{1-y}(Ga₁₋ₓAℓₓ)_{y} P (0 ≤ x < 1, y = 0.5), and an n-type InGaAℓP cladding layer (3), said active layer (4) being sandwiched between said cladding layers (3) and (5), characterised in that an n-type dopant, which does not change the crystal structure of said active layer (4), is doped in said active layer (4).

2. A semiconductor light-emitting element according to claim 1, characterized in that said dopant is Si.

3. A semiconductor light-emitting element according to claim 1, characterized in that said active layer (4) consists of In_{0.5}Ga_{0.5}P.

4. A semiconductor light-emitting element according to claim 1, characterized in that said active layer (4) consists of In_{0.5} (Ga_{0.8} Aℓ_{0.2}) _{0.5}P.

5. A semiconductor light-emitting element according to claim 1, characterized in that said semiconductor light-emitting element is a semiconductor laser element having an oscillation wavelength of about 670 nm.

6. A semiconductor light-emitting element according to claim 1, characterized by: an n-type GaAs substrate (1);
an n-type GaAs buffer layer (2) on the substrate (1), the buffer layer (2) having a donor concentration of 5 × 10¹⁷ atoms/cm³ and a thickness of 0.5 µm;
an n-type In_{1-y} (Ga₁₋ₛAℓₛ)_{y} P cladding layer (3) on the buffer layer (2) and having a donor concentration of 5 × 10¹⁷ atoms/cm³ and a thickness of 0.9 µm;
said n-type active layer (4) on the cladding layer (3) having a donor concentration of 1 × 10¹⁹ atoms/cm³ and a thickness of 0.06 µm;
a p-type In_{1-y} (Ga₁₋ₛAℓₛ)_{y} P cladding layer (5) on the active layer (4) having an acceptor concentration of 3 × 10¹⁷ atoms/cm³ and a thickness of 0.9 µm;
an n-type GaAs current stripe layer (6) on the cladding layer (5), the current stripe layer (6) having a stripe window portion (8), a donor concentration of 2 × 10¹⁸ atoms/cm³ and a thickness of 0.6 µm;
a p-type GaAs ohmic contact layer (7) on the current stripe layer (6); and
metallic electrodes (9,10) on the ohmic contact layer (7) and the substrate (1), respectively;
wherein said semiconductor light-emitting element is a semiconductor laser element.

7. A semiconductor light-emitting element according to claim 1, characterized by
an n-type GaAs substrate (12);
an n-type GaAs buffer layer (13) on the substrate (12);
an n-type In_{0.5} (Ga_{0.3} Aℓ_{0.7}) _{0.5} P cladding layer (14) on the buffer layer (13);
an n-type In_{0.5} (Ga_{0.8} Aℓ_{0.2})_{0.5} P active layer (15) on the cladding layer (14);
a p-type In_{0.5} (Ga_{0.3} Aℓ_{0.7}) _{0.5} P cladding layer (16) on the active layer (15);
a p-type GaAℓAs conductive layer (17) on the cladding layer (16);
a p-type GaAs contact layer (18) on the conductive layer (17); and
metallic electrodes on the ohmic contact layer (7) and the substrate (1), respectively;
wherein said semiconductor light-emitting element is a light emitting diode.

8. A method for manufacturing a semiconductor light-emitting element having a double hetero junction structure, comprising the steps of:
forming an n-type InGaAℓP cladding layer (3);
forming an active layer (4) of In_{1-y} (Ga₁₋ₓAℓₓ)_{y} P (0≤ x <1, y=0.5) including an n-type dopant which does not change the crystal structure of the active layer (4), on said cladding layer (3);
forming a p-type InGaAℓP cladding layer (5) on said active layer (4), whereby a layer structure to sandwich said n-type active layer between the layers is formed.

9. A method according to claim 8, characterized in that said n-type dopant is Si.

10. A method according to claim 8, characterised in that said active layer (4) consists of In_{0.5}Ga_{0.5}P.

11. A method according to claim 8, characterized in that said active layer (4) consists of In_{0.5} (Ga_{0.8}Aℓ_{0.2}) _{0.5} P.

12. A method according to claim 8 for manufacturing a laser element, comprising the steps of:
sequentially forming an n-type GaAs substrate (1), an n-type GaAs buffer layer (2) having a donor concentration of 5 x 10¹⁷ atoms/cm³ and a thickness of 0.5 µm, said n-type cladding layer as a In_{1-y} (Ga₁₋ₛAℓₛ) _{y} P cladding layer (3) having a donor concentration of 5 x 10¹⁷ atoms/cm³ and a thickness of 0.9 µm, said n-type In_{1-y} (Ga₁₋ₓAℓₓ)_{y} P active layer (4) having a donor concentration of 1 x 10¹⁹ atoms/cm³ and a thickness of 0.06 µm, said p-type cladding layer as a In_{1-y} (Ga₁₋ₛAℓₛ)_{y} P cladding layer (5) having an acceptor concentration of 3 x 10¹⁷ atoms/cm³ and a thickness of 0.9 µm, and an n-type GaAs current stripe layer (6) having donor concentration of 2 x 10¹⁸ atoms/cm³ and a thickness of 0.6 µm;
forming a resist film (11) having a stripe-shaped opening on said current stripe layer (6) by a photolithography method;
etching said current stripe layer (6) by use of said resist film (11) as a mask, thereby forming a stripe-shaped window (8);
removing said resist film (11) and performing a surface cleaning process;
forming a p-type GaAs ohmic contact layer (7) on the upper portion by an MOCVD method; and
adhering metallic electrodes (9) and (10) onto the ohmic contact layer (7) and the substrate (1), respectively by a vapour deposition method.

## Patentansprüche

1. Lichtemittierendes Halbleiterelement mit einer Doppelheteroübergangsanordnung, gebildet durch stapelförmige Anordnung einer Mantelschicht (5) des p-Typs aus InGaAℓP mit einer Bandlückenenergie, die größer ist als jene einer aktiven Schicht (4) aus In_{1-y}(Ga₁₋ₓAℓₓ)_{y}P (0 ≤ x < 1, y = 0,5), und einer Mantelschicht (3) des n-Typs aus InGaAℓP, wobei die aktive Schicht (4) sandwichartig zwischen den Mantelschichten (3) und (5) angeordnet ist, dadurch **gekennzeichnet**, daß ein Dotiermittel des n-Typs, welches nicht die Kristallstruktur der aktiven Schicht (4) ändert, in die aktive Schicht (4) eindotiert ist.

2. Lichtemittierendes Halbleiterelement nach Anspruch 1, dadurch gekennzeichnet, daß das Dotiermittel Si ist.

3. Lichtemittierendes Halbleiterelement nach Anspruch 1, dadurch gekennzeichnet, daß die aktive Schicht (4) aus In_{0,5}Ga_{0,5}P besteht.

4. Lichtemittierendes Halbleiterelement nach Anspruch 1, dadurch gekennzeichnet, daß die aktive Schicht (4) aus In_{0,5}(Ga_{0,8} Aℓ_{0,2})_{0,5}P besteht.

5. Lichtemittierendes Halbleiterelement nach Anspruch 1, dadurch gekennzeichnet, daß das lichtemittierende Halbleiterelement ein Halbleiterlaserelement ist, welches eine Oszillationswellenlänge von etwa 670 nm aufweist.

6. Lichtemittierendes Halbleiterelement nach Anspruch 1, gekennzeichnet durch:
ein GaAs-Substrat (1) des n-Typs;
eine GaAs-Pufferschicht (2) des n-Typs auf dem Substrat (1), wobei die Pufferschicht (2) eine Donatorkonzentration von 5 x 10¹⁷ Atomen/cm³ und eine Dicke von 0,5 µm aufweist;
eine Mantelschicht (3) des n-Typs aus In_{1-y} (Ga₁₋ₛAℓₓ)_{y} P auf der Pufferschicht (2) mit einer Donatorkonzentration von 5 x 10¹⁷ Atomen/cm³ und einer Dicke von 0,9 µm;
wobei die aktive Schicht (4) des n-Typs auf der Mantelschicht (3) eine Donatorkonzentration von 1 x 10¹⁹ Atomen/cm³ und eine Dicke von 0,06 µm aufweist;
eine Mantelschicht (5) des p-Typs aus In_{1-y}(Ga₁₋ₓAℓₛ)_{y}P auf der aktiven Schicht (4) mit einer Akzeptorkonzentration von 3 x 10¹⁷ Atomen/cm³ und einer Dicke von 0,9 µm;
eine GaAs-Stromstreifenschicht (6) des˙n-Typs auf der Mantelschicht (5), wobei die Stromstreifenschicht (6) einen Streifenfensterabschnitt (8), eine Donatorkonzentration von 2 x 10¹⁸ Atomen/cm³ und eine Dicke von 0,6 µm aufweist;
eine ohm'sche Kontaktschicht (7) des p-Typs aus GaAs auf der Stromstreifenschicht (6); und
Metallelektroden (9, 10) auf der ohm'schen Kontaktschicht (7) bzw. dem Substrat (1);
wobei das lichtemittierende Halbleiterelement ein Halbleiterlaserelement ist.

7. Lichtemittierendes Halbleiterelement nach Anspruch 1, gekennzeichnet durch:
ein GaAs-Substrat (12) des n-Typs;
eine GaAs-Pufferschicht (13) des n-Typs auf dem Substrat (12);
eine Mantelschicht (14) des n-Typs aus In_{0,5}(Ga_{0,3}Aℓ_{0,7})_{0,5}P auf der Pufferschicht (13);
eine aktive Schicht (15) des n-Typs aus In_{0,5}(Ga_{0,8}Aℓ_{0,2})_{0,5}P auf der Mantelschicht (14);
eine Mantelschicht (16) des P-Typs aus In_{0,5}(Ga_{0,3}Aℓ_{0,7})_{0,5}P auf der aktiven Schicht (15);
eine leitfähige Schicht (17) des p-Typs aus GaAℓAs auf der Mantelschicht (16);
eine GaAs-Kontaktschicht (18) des p-Typs auf der leitfähigen Schicht (17); und
Metallelektroden auf der ohm'schen Kontaktschicht (7) bzw. auf dem Substrat (1);
wobei das lichtemittierende Halbleiterelement eine lichtemittierende Diode ist.

8. Verfahren zur Herstellung eines lichtemittierenden Halbleiterelements, welches eine Doppelheteroübergangsanordnung aufweist, mit folgenden Schritten:
Ausbildung einer Mantelschicht (3) des n-Typs aus InGaAℓP;
Ausbildung einer aktiven Schicht (4) aus In_{1-y}(Ga₁₋ₓAℓₓ)_{y}P (0 ≤ x < 1, y = 0,5) mit einem Dotiermittel des n-Typs, welches nicht die Kristallstruktur der aktiven Schicht (4) ändert, auf der Mantelschicht (3);
Ausbildung einer Mantelschicht (5) des p-Typs aus InGaAℓP auf der aktiven Schicht (4), wodurch eine Schichtanordnung zum sandwichartigen Einschließen der aktiven Schicht des n-Typs zwischen den Schichten ausgebildet wird.

9. Verfahren nach Anspruch 8, dadurch gekennzeichnet, daß das Dotiermittel des n-Typs Si ist.

10. Verfahren nach Anspruch 8, dadurch gekennzeichnet, daß die aktive Schicht (4) aus In_{0,5}Ga_{0,5}P besteht.

11. Verfahren nach Anspruch 8, dadurch gekennzeichnet, daß die aktive Schicht (4) aus In_{0,5}(Ga_{0,8}Aℓ_{0,2})_{0,5}P besteht.

12. Verfahren nach Anspruch 8 zur Herstellung eines Laserelements mit folgenden Schritten:
aufeinanderfolgendes Ausbilden eines GaAs-Substrats (1) des n-Typs, einer GaAs-Pufferschicht (2) des n-Typs mit einer Donatorkonzentration von 5 x 10¹⁷ Atomen/cm³ und einer Dicke von 0,5 µm, der Mantelschicht des n-Typs als einer Mantelschicht (3) aus In_{1-y}(Ga₁₋ₛAℓₛ)_{y}P mit einer Donatorkonzentration von 5 x 10¹⁷ Atomen/cm³ und einer Dicke von 0,9 µm, der aktiven Schicht (4) des n-Typs aus In_{1-y}(Ga₁₋ₓAℓₓ)_{y}P mit einer Donatorkonzentration von 1 x 10¹⁹ Atomen/cm³ und einer Dicke von 0,06 µm, der Mantelschicht des p-Typs als einer Mantelschicht (5) aus In_{1-y}(Ga₁₋ₛAℓₛ)_{y}P mit einer Akzeptorkonzentration von 3 x 10¹⁷ Atomen/cm³ und einer Dicke von 0,9 µm, und einer GaAs-Stromstreifenschicht (6) des n-Typs mit einer Donatorkonzentration von 2 x 10¹⁸ Atomen/cm³ und einer Dicke von 0,6 µm;
Ausbildung eines Fotolackfilms (11), der eine streifenförmige Öffnung aufweist, auf der Stromstreifenschicht (6) durch ein fotolithographisches Verfahren;
Ätzen der Stromstreifenschicht (6) unter Verwendung des Fotolackfilms (11) als Maske, wodurch ein streifenförmiges Fenser (8) ausgebildet wird;
Entfernen des Fotolackfilms (11) und Durchführung eines Oberflächenreinigungsvorgangs;
Ausbildung einer ohm'schen Kontaktschicht (7) des p-Typs aus GaAs auf dem oberen Abschhnitt durch ein MOCVD-Verfahren; und
Befestigen von Metallelektroden (9) und (10) auf der ohm'schen Kontaktschicht (7) bzw. dem Substrat (1) durch ein Dampfablagerungsverfahren.

## Revendications

1. Elément émetteur de lumière à semiconducteur comprenant une structure à double hétérojonction formée en empilant une couche de gainage en InGaAlP de type p (5) présentant une énergie de bande interdite qui est supérieure à celle d'une couche active (4) en In_{1-y}(Ga₁₋ₓAlₓ)_{y}P (0 ≤ x < 1, y = 0,5), et une couche de gainage en InGaAlP de type n (3), ladite couche active (4) étant prise en sandwich entre lesdites couches de gainage (3) et (5), caractérisé en ce qu'un dopant de type n qui ne modifie pas la structure cristalline de ladite couche active (4) est dopé dans ladite couche active (4).

2. Elément émetteur de lumière à semiconducteur selon la revendication 1, caractérisé en ce que ledit dopant est du Si.

3. Elément émetteur de lumière à semiconducteur selon la revendication 1, caractérisé en ce que ladite couche active (4) est constituée par de l'In_{0,5}Ga_{0,5}P.

4. Elément émetteur de lumière à semiconducteur selon la revendication 1, caractérisé en ce que ladite couche active (4) est constituée par de l'In_{0,5} (Ga_{0,8}Al_{0,2})_{0,5}P.

5. Elément émetteur de lumière à semiconducteur selon la revendication 1, caractérisé en ce que ledit élément émetteur de lumière à semiconducteur est un élément de laser à semiconducteur présentant une longueur d'onde d'oscillation d'environ 670 nm.

6. Elément émetteur de lumière à semiconducteur selon la revendication 1, caractérisé par :
un substrat en GaAs de type n (1);
une couche tampon en GaAs de type n (2) sur le substrat (1), la couche tampon (2) présentant une concentration de donneur de 5 x 10¹⁷ atomes/cm³ et une épaisseur de 0,5 µm ;
une couche de gainage en In_{1-y}(Ga₁₋ₛAlₛ)_{y}P de type n (3) sur la couche tampon (2) et présentant une concentration de donneur de 5 x 10¹⁷ atomes/cm³ et une épaisseur de 0,9 µm ;
ladite couche active de type n (4) sur la couche de gainage (3) présentant une concentration de donneur de 1 x 10¹⁹ atomes/cm³ et une épaisseur de 0,06 µm ;
une couche de gainage en In_{1-y}(Ga₁₋ₛAlₛ)_{y}P de type p (5) sur la couche active (4) et présentant une concentration d'accepteur de 3 x 10¹⁷ atomes/cm³ et une épaisseur de 0,9 µm ;
une couche de bande de courant en GaAs de type n (6) sur la couche de gainage (5), la couche de bande de courant (6) comportant une partie de fenêtre en bande (8), présentant une concentration de donneur de 2 x 10¹⁸ atomes/cm³ et une épaisseur de 0,6 µm ;
une couche de contact ohmique en GaAs de type p (7) sur la couche de bande de courant (6) ; et
des électrodes métalliques (9, 10) respectivement sur la couche de contact ohmique (7) et sur le substrat (1),
dans lequel ledit élément émetteur de lumière à semiconducteur est un élément de laser à semiconducteur.

7. Elément émetteur de lumière à semiconducteur selon la revendication 1, caractérisé par :
un substrat en GaAs de type n (12) ;
une couche tampon en GaAs de type n (13) sur le substrat (12) ;
une couche de gainage en In_{0,5}(Ga_{0,3}Al_{0,7})_{0,5}P de type n (14) sur la couche tampon (13);
une couche active en In_{0,5}(Ga_{0,8}Al_{0,2})_{0,5}P de type n (15) sur la couche de gainage (14) ;
une couche de gainage en In_{0,5}(Ga_{0,3}Al_{0,7})_{0,5}P de type p (16) sur la couche active (15) ;
une couche conductrice en GaAlAs de type p (17) sur la couche de gainage (16) ;
une couche de contact en GaAs de type p (18) sur la couche conductrice (17) ; et
des électrodes métalliques respectivement sur la couche de contact ohmique (7) et sur le substrat (1),
dans lequel ledit élément émetteur de lumière à semiconducteur est une diode émettrice de lumière.

8. Procédé de fabrication d'un élément émetteur de lumière à semiconducteur présentant une structure à double hétérojonction, comprenant les étapes de :
formation d'une couche de gainage en InGaAlP de type n (3) ;
formation d'une couche active (4) en In_{1-y}(Ga₁₋ₓAlₓ)_{y}P (0 ≤ x < 1, y = 0,5) incluant un dopant de type n qui ne modifie pas la structure cristalline de la couche active (4), sur ladite couche de gainage (3) ;
formation d'une couche de gainage en InGaAlP de type p (5) sur ladite couche active (4) de telle sorte qu'une structure de couche qui prenne en sandwich ladite couche active de type n entre les couches soit formée.

9. Procédé selon la revendication 8, caractérisé en ce que ledit dopant de type n est du Si.

10. Procédé selon la revendication 8, caractérisé en ce que ladite couche active (4) est constituée par de l'In_{0,5}Ga_{0,5}P.

11. Procédé selon la revendication 8, caractérisé en ce que ladite couche active (4) est constituée par de l'In_{0,5}(Ga_{0,8}Al_{0,2})_{0,5}P.

12. Procédé selon la revendication 8 de fabrication d'un élément de laser, comprenant les étapes de :
formation séquentielle d'un substrat en GaAs de type n (1), d'une couche tampon en GaAs de type n (2) présentant une concentration de donneur de 5 x 10¹⁷ atomes/cm³ et une épaisseur de 0,5 µm, de ladite couche de gainage de type n en tant que couche de gainage en In_{1-y}(Ga₁₋ₛAlₛ)_{y}P (3) présentant une concentration de donneur de 5 x 10¹⁷ atomes/cm³ et une épaisseur de 0,9 µm, de ladite couche active en In_{1-y}(Ga₁₋ₓAlₓ)_{y}P de type n (4) présentant une concentration de donneur de 1 x 10¹⁹ atomes/cm³ et une épaisseur de 0,06 µm, de ladite couche de gainage de type p en tant que couche de gainage en In_{1-y}(Ga₁₋ₛAlₛ)_{y}P (5) présentant une concentration d'accepteur de 3 x 10¹⁷ atomes/cm³ et une épaisseur de 0,9 µm, et d'une couche de bande de courant en GaAs de type n (6) présentant une concentration de donneur de 2 x 10¹⁸ atomes/cm³ et une épaisseur de 0,6 µm ;
formation d'un film de réserve (11) comportant une ouverture en forme de bande sur ladite couche de bande de courant (6) au moyen d'un procédé de photolithographie ;
gravure de ladite couche de bande de courant (6) au moyen de l'utilisation dudit film de réserve (11) en tant que masque pour ainsi former une fenêtre en forme de bande (8) ;
enlèvement dudit film de réserve (11) et réalisation d'un processus de nettoyage de surface ;
formation d'une couche de contact ohmique en GaAs de type p (7) sur la partie supérieure au moyen d'un procédé de dépôt chimique en phase vapeur d'organo-métallique (MOCVD) ; et
application adhérente d'électrodes métalliques (9) et (10) respectivement sur la couche de contact ohmique (7) et sur le substrat (1) au moyen d'un procédé de dépôt en phase vapeur.
